# EUROPEAN PATENT APPLICATION

(11) **EP 4 421 672 A1**
(43) Date of publication of application: **28.08.2024**
(21) Application number: 23845012.6
(22) Date of filing: 18.05.2023
(51) Int. Cl.: G06F 30/392

(54) **CHIP LAYOUT WIRING METHOD AND APPARATUS, DEVICE, STORAGE MEDIUM AND CHIP LAYOUT**

(30) Priority: 26.07.2022 CN 202210887533
(71) Applicant: Tencent Technology (Shenzhen) Company Limited, Shenzhen, Guangdong, 518057 (CN)
(72) Inventor: MA, Shengming, Shenzhen, Guangdong 518057 (CN); CHEN, Yue, Shenzhen, Guangdong 518057 (CN); WANG, Jianming, Shenzhen, Guangdong 518057 (CN); HUAI, Sainan, Shenzhen, Guangdong 518057 (CN); ZHANG, Shengyu, Shenzhen, Guangdong 518057 (CN); WANG, Xuemeng, Shenzhen, Guangdong 518057 (CN); XU, Xiong, Shenzhen, Guangdong 518057 (CN); LI, Yanghepu, Shenzhen, Guangdong 518057 (CN)
(74) Representative: Reddie & Grose LLP
(86) International application number: PCT/CN2023/095122
(87) International publication number: WO 2024/021797

(57) **Abstract**

The present application discloses a chip layout wiring method and apparatus, a device, a storage medium and a chip layout, and relates to the technical field of chips. The method comprises: acquiring a chip layout to be wired, and wiring planning information corresponding to the chip layout; the wiring planning information comprising planning information for a first point location in the chip layout, the planning information of the first point location being used for defining a location area, wiring orientation, and planning track of the first point location, and a first end of the planning track being connected to the first point location (410); according to the location area and the wiring orientation, providing a second point location for connecting the chip layout, and a first wiring segment for a second end of the planning track (420); according to the planning track, arranging a second end connected to the planning track, and a second wiring segment of the first point location (430); and according to the first wiring segment and the second wiring segment, arranging connection wiring (440) between the second point location and the first point location. The present application can achieve automatic wiring and improves the accuracy of automatic wiring.

## Description

### RELATED APPLICATION

This application claims priority to Chinese Patent Application No. 202210887533.0, filed with the China National Intellectual Property Administration on July 26th, 2022 and entitled "CHIP LAYOUT WIRING METHOD AND APPARATUS, DEVICE, STORAGE MEDIUM AND CHIP LAYOUT".

### FIELD OF THE TECHNOLOGY

Embodiments of this application relate to the field of chip technologies, and in particular, to a routing method and apparatus for a chip layout, a device, a storage medium, and a chip layout.

### BACKGROUND OF THE DISCLOSURE

In a superconducting quantum chip, there are a plurality of pads on an edge of a chip layout (or referred to as a circuit layout). The pad is a port used by a chip to connect to the outside world. A peripheral element, a module, and a peripheral are connected to the pad through a pin. For the chip, the pads need to be connected to other elements in the chip, and lines need to be laid out during layout design using an electronic design automation (EDA) tool.

For layout routing of the superconducting quantum chip, routing efficiency of the currently used method is low.

### SUMMARY

Embodiments of this application provide a routing method and apparatus for a chip layout, a device, a storage medium, and a chip layout. Technical solutions are as follows:

According to an aspect of the embodiments of this application, a routing method for a chip layout is provided, the method being performed by a computer device and including:
obtaining a to-be-routed chip layout and routing planning information corresponding to the chip layout, the routing planning information including planning information of a first site in the chip layout, the planning information of the first site defining a location region, a routing orientation, and a planning guidance path that are of the first site, and a first end of the planning guidance path being connected to the first site;
obtaining, according to the routing orientation, a first route segment connecting a second site of the chip layout and a second end of the planning guidance path;
obtaining, based on the planning guidance path, a second route segment connecting the second end of the planning guidance path and the first site; and
obtaining, based on the first route segment and the second route segment, a connection route between the second site and the first site.

According to an aspect of the embodiments of this application, a routing apparatus for a chip layout is provided, the apparatus including:
an obtaining module, configured to obtain a to-be-routed chip layout and routing planning information corresponding to the chip layout, the routing planning information including planning information of a first site in the chip layout, the planning information of the first site defining a location region, a routing orientation, and a planning guidance path that are of the first site, and a first end of the planning guidance path being connected to the first site;
a routing module, configured to obtain, according to the routing orientation, a first route segment connecting a second site of the chip layout and a second end of the planning guidance path; obtain, based on the planning guidance path, a second route segment connecting the second end of the planning guidance path and the first site; and obtain, based on the first route segment and the second route segment, a connection route between the second site and the first site.

According to an aspect of the embodiments of this application, a computer device is provided, the computer device including a processor and a memory, the memory storing a computer program, the processor being configured to execute the computer program to implement the foregoing method.

According to an aspect of the embodiments of this application, a computer-readable storage medium is provided, the computer-readable storage medium storing a computer program, the computer program being loaded and executed by a processor to implement the foregoing method.

According to an aspect of the embodiments of this application, a computer program product is provided, the computer program product including a computer program, the computer program being loaded and executed by a processor to implement the foregoing method.

According to an aspect of the embodiments of this application, a chip layout is provided, the chip layout being obtained by using the foregoing method.

The technical solutions provided in the embodiments of this application can bring the following beneficial effects:
Through the routing planning information corresponding to the chip layout, the location region, the routing orientation, and the planning guidance path that are of each site included in the chip layout are defined, so that an automatic routing program can automatically arrange routes connecting each point, thereby improving routing efficiency. In addition, by defining the location region, the routing orientation, and the planning guidance path that are of the site, the automatic routing program can accurately locate the site, connect to the site from an accurate orientation when arranging a route connecting the site, and connect to the site along a path planned along the planning guidance path when approaching the site, which can effectively avoid a problem of an inaccurate connection location or even connection failure, improving routing accuracy.

### BRIEF DESCRIPTION OF THE DRAWINGS

FIG. 1 is a schematic diagram of a routing result obtained by using a conventional topology routing algorithm according to an embodiment of this application.
FIG. 2 is a schematic diagram of a passenger plane landing at an airport according to an embodiment of this application.
FIG. 3 is a schematic diagram of routing planning information of a site in a chip layout according to an embodiment of this application.
FIG. 4 is a flowchart of a routing method for a chip layout according to an embodiment of this application.
FIG. 5 is a schematic diagram of a location region corresponding to a pad according to an embodiment of this application.
FIG. 6 is a schematic diagram of an entry orientation corresponding to a pad according to an embodiment of this application.
FIG. 7 is a schematic diagram of a planning guidance path corresponding to a pad according to an embodiment of this application.
FIG. 8 is a schematic diagram of a routing result corresponding to a pad according to an embodiment of this application.
FIG. 9 is a schematic diagram of topology routing according to an embodiment of this application.
FIG. 10 is a schematic diagram of routing planning information corresponding to a pad according to an embodiment of this application.
FIG. 11 is a flowchart of entry path planning and automatic routing according to an embodiment of this application.
FIG. 12 is a schematic diagram of an unrouted pad according to an embodiment of this application.
FIG. 13 is a schematic diagram of a pad with planning information according to an embodiment of this application.
FIG. 14 is a schematic diagram of a routing result corresponding to a pad according to an embodiment of this application.
FIG. 15 is a block diagram of a routing apparatus for a chip layout according to an embodiment of this application.
FIG. 16 is a structural block diagram of a computer device according to an embodiment of this application.

### DESCRIPTION OF EMBODIMENTS

To make objectives, technical solutions, and advantages of this application clearer, the following further describes implementations of this application in detail with reference to the accompanying drawings.

Before the embodiments of this application are described, some terms involved in this application are explained first.
1. Superconducting quantum chip: It is a central processing unit of a superconducting quantum computer. The quantum computer is a machine that performs calculations by using a principle of quantum mechanics. Based on a superposition principle of quantum mechanics and quantum entanglement, the quantum computer has strong parallel processing capabilities and can resolve some problems that are difficult for a classical computer to calculate. A zero resistance characteristic of a superconducting qubit and a manufacturing process close to that of an integrated circuit make a quantum computing system constructed by using the superconducting qubit one of the most promising systems currently for implementing practical quantum computing.
2. Layout: It is also referred to as a circuit layout, and is a design drawing that describes how an element in a circuit is laid out, placed, and connected. The layout is planar geometric description of a physical condition of a real circuit. Layout design complies with constraints such as a manufacturing process, a time sequence, an area, and power consumption. A layout design file includes a shape, an area, and location information that are of each hardware unit on a chip.
3. Pad: It exists on a circuit board, and is a location configured for connecting an electronic element and a line. Solder is generally used on the pad to weld and fix a pin of the element to the circuit board. In a classic circuit, the pad is generally a polygonal copper sheet. In a superconducting quantum chip, the pad has a different shape and structure.
4. Element: It is a general term for a component and a device, and is an electronic component and a constituent element, such as a resistor, a capacitor, or an inductor, in a circuit.
5. Peripherals: A full name thereof is external equipment, and the peripherals are devices and equipment connected to a body (for example, a chip) around the body. The peripherals are non-essential hardware equipment runnable when being powered on, and can work independently or semi-independently. The peripherals are not dependent on the body, and are generally configured to expand and improve a function and performance that are of the body. For example, for a computer, peripherals of the computer include a mouse, a keyboard, and the like.
6. Pin: It is an interface that is on an element and is configured to connect to the outside world, and is generally a metal conductor exposed outside. Pins on a conventional element are several pins that can be connected to a pad on a circuit board or inserted into jacks on a breadboard. Nowadays, in a highly integrated circuit, the pins are generally metal patches.
7. Electronic design automation (EDA): It is a design method in the electronic field, and refers to using computer software (auxiliary design software) to complete design work in the electronic field and implement design automation. Processes such as functional design, functional verification, layout routing that are of an integrated circuit chip are included. Software tools used in this category are collectively referred to as EDA tools.
8. Automatic routing: It refers to using software to automatically complete arrangement of lines in circuit and chip design and connecting elements according to a rule and a requirement, and is mostly used in large-scale and ultra-large-scale integrated circuit design in which automatic routing is a link. The automatic routing is generally performed after a layout is completed.
9. Sinuosity: For a continuously differentiable curve with at least one inflection point, the sinuosity is a ratio of a curvilinear length between endpoints of a curve to a Euclidean distance. The sinuosity is also referred to as a sinuosity index or a sinuosity coefficient.
10. Topology: Topology is a discipline that studies topological space, and is developed from geometry and set theory. The topology mainly studies a property that is of a geometric figure or space and remains unchanged after a shape is continuously changed. The topology studies concepts such as space, dimension, and transformation. Only a location relationship between objects, instead of a shape and a size, is considered in the topology.
11. Irregular polygon: It is a counterexample of a regular polygon, and is a polygon in which all sides are not all equal and all angles are not all equal on a two-dimensional plane.
12. Concave polygon: It is a counterexample of a convex polygon. The concave polygon has at least one interior angle greater than 180 degrees and less than 360 degrees. One concave polygon may be decomposed into a plurality of (sets of) convex polygons.
13. Vertex: A vertex of a polygon is an intersection of two or more sides, line segments, or curves. A quantity of vertices of a polygon is equal to a quantity of sides of the polygon. A vertex of a polyhedron is an endpoint of an angle (included angle) or a vertex angle formed by two intersecting edges.
14. Co-Planar Waveguide (CPW): It is a microwave planar transmission line with superior performance and convenient processing, and is configured for transmitting a microwave signal. A large amount of co-planar waveguide technologies are used in a superconducting quantum chip.
15. Candidate point: It is a point that may be connected or to be connected during automatic routing, and meets a condition and a routing rule. The candidate point is related to a routing algorithm and may also be manually generated to standardize a connection.

Compared with a conventional electronic integrated circuit, a superconducting quantum chip has some special properties. In one aspect, the superconducting quantum chip includes a plurality of components with different shapes, and an electrical characteristic thereof is very sensitive. When line arrangement is performed, it is necessary to try to avoid affecting a circuit component. In another aspect, as a quantity of qubits increases, a quantity of bit control and readout lines also increases. Based on a calculation that each bit has two control lines and five bits share one readout line, for a quantum processor with N bits, at least 11N/5 lines connected to a pad are required, where N is a positive integer. In addition, because the superconducting quantum chip is based on a CPW structure, the complex geometric structure and changeable placement and orientation of the pad make it difficult to identify a specific orientation of the pad and accurately connect the pad to a desirable location during automatic routing. Therefore, for the superconducting quantum chip, due to particularity and complexity of the structure thereof, artificial routing is mostly used currently.

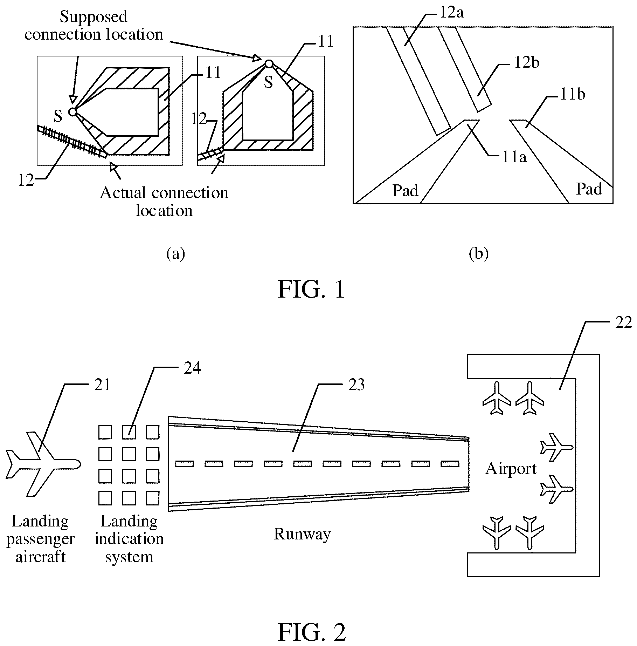

It is assumed that a conventional topology routing algorithm is used. The conventional topology routing algorithm is mainly aimed at solving a routing requirement in the conventional electronic integrated circuit. However, different from a circuit characteristic of a conventional semiconductor chip, a circuit principle and structural design of the quantum chip do not follow exactly same logic. Therefore, the conventional topology routing algorithm is not fully applicable to superconducting quantum chip design. The conventional topology routing algorithm cannot identify a designated location of a polygonal pad (pattern) on a layout, resulting in an inaccurate connection location of the line and the pad, or even failure to connect smoothly, which does not satisfy a layout routing requirement. For example, as shown in FIG. 1, a connection location of a pad 11 is a point S in the figure. It may be seen from a sub-figure (a) in FIG. 1 that a connection location between a line 12 and the pad 11 is inaccurate, and the line 12 is not accurately connected to the point S. It may be seen from a sub-figure (b) in FIG. 1 that the two left and right lines 12a and 12b need to be connected to a left connection location 11a and a right connection location 11b of the pad 11 respectively, but connection is not performed smoothly.

Based on this, this application provides a routing method for a chip layout, which can implement automatic routing for the chip layout. In addition, the technical solutions of this application are applicable not only to automatic layout routing for a quantum chip (for example, a superconducting quantum chip), but also to automatic layout routing for a conventional electronic integrated circuit.

In superconducting quantum chip design, due to a property and a feature of superconducting quantum, a superconducting quantum chip layout has some differences from conventional integrated circuit chip design. For example, a pad at an edge of a chip is formed by an irregular concave polygon (for example, the pad 11 shown in FIG. 1). Due to a complex shape and a large quantity of sides, and different placement locations and directions of different pads on a layout, when automatic routing is performed on the layout, an unacceptable case such as a line not connecting to the pad or connecting to a wrong location on the pad is prone to occur. To resolve the problem, it is necessary to specify how the line is connected to the pad.

This application is inspired by an airport runway. As shown in FIG. 2, before a passenger aircraft 21 is about to land at an airport 22, a pilot needs to know information such as a location and a direction of a runway 23, and then land on the runway 23, so that there is an indication system 24 in front of the runway 23 of the airport to guide the passenger aircraft 21 and the pilot to perform a landing operation.

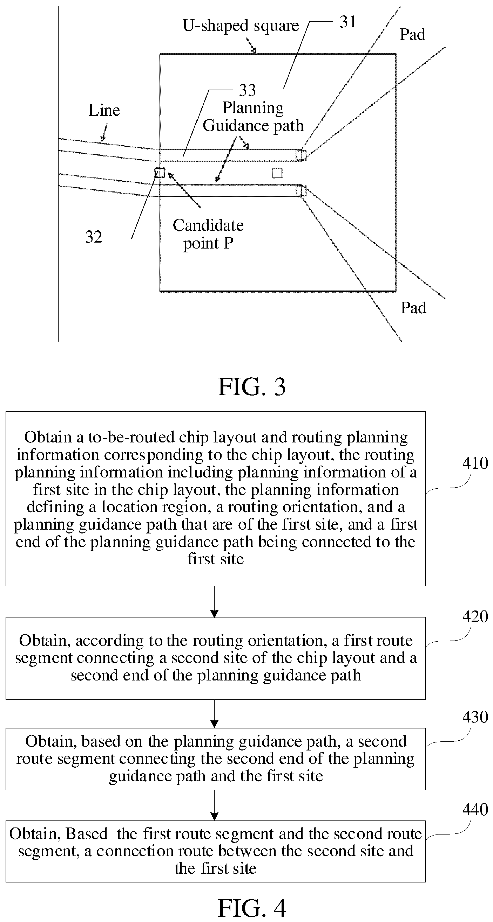

What is achieved in this application is to add the indication system and the airport to routing. Similar to landing of the aircraft, it is expected that the line in the layout can also accurately "land" at a predetermined location of the pad. A method of this application is shown in FIG. 3. For any site on a chip layout, a location region 31 (corresponding to the "airport"), a routing orientation 32 (corresponding to the "indication system"), and a planning guidance path 33 (corresponding to the "runway" in the airport) that are of the site are pre-defined. For example, the location region 31 may be a region surrounded by a U-shaped square, the planning guidance path 33 is a straight line (due to a CPW technology in superconducting quantum, the line is formed by two parallel wires), and the routing orientation 32 may be indicated by using a candidate point P. The three together constitute this set of docking technologies for guiding docking of the line and the site (for example, a pad).

FIG. 4 is a flowchart of a routing method for a chip layout according to an embodiment of this application. The method may be performed by a computer device. The computer device may be any electronic device with computing and storage capabilities, such as a personal computer (PC), a tablet computer, or a server. For example, a computer program for performing the method may be run in the computer device, and an automatic routing method provided in this embodiment can be implemented through the computer program. As shown in FIG. 4, the method may include at least one of the following several steps 410 to 440.

Step 410: Obtain a to-be-routed chip layout and routing planning information corresponding to the chip layout. The routing planning information includes planning information of a first site in the chip layout, the planning information of the first site defines a location region, a routing orientation, and a planning guidance path that are of the first site, and a first end of the planning guidance path is connected to the first site.

The chip layout may be a chip layout of a quantum chip, for example, a chip layout of a superconducting quantum chip, or may be a chip layout of a conventional electronic integrated circuit. This is not limited in this embodiment of this application. The automatic routing solution provided in this embodiment of this application is applicable to automatic routing for the chip layout of the quantum chip, and is also applicable to automatic routing for the chip layout of the conventional electronic integrated circuit.

The routing planning information corresponding to the chip layout includes planning information of at least one site in the chip layout. Optionally, the routing planning information includes the planning information of the first site in the chip layout, and the first site may be any site in the chip layout. For example, the foregoing site may be a pad, or may be an endpoint of an element, or another element that needs to be connected to a line. For example, the first site is a pad.

In some embodiments, the pad is of a concave polygonal structure, and the pad includes at least one connection point. For example, in FIG. 1, the pad 11 is of a concave polygonal structure, and the pad 11 includes two connection points, as shown in the left connection location 11a and the right connection location 11b in the figure.

In some embodiments, the planning information of the site is configured for defining the location region, the routing orientation, and the planning guidance path that are of the site. The location region of the site is configured for defining a location of the site on the chip layout, and the location may be represented by a region. The routing orientation of the site is configured for defining, when a line is connected to the site, an orientation from which the line is connected to the site, for example, from above, below, left, or right of the site. The planning guidance path of the site is configured for guiding the line to be connected to the site along the planning guidance path when approaching the site. The planning guidance path may also be referred to as a planned path, and is a path that is pre-planned for connecting to the first site.

For specific parameter information of the location region, the routing orientation, and the planning guidance path that are of the site described herein, reference may be made to an embodiment below, and details are not described herein.

By using the foregoing first site as an example, the planning information of the first site is configured for defining the location region, the routing orientation, and the planning guidance path that are of the first site.

In some embodiments, the location region of the first site is defined by using a plane graphic surrounding a reference point corresponding to the first site, and the routing orientation of the first site is defined on an edge of the plane graphic. Optionally, the plane graphic is a rectangle, and the routing orientation is defined on an edge of the rectangle.

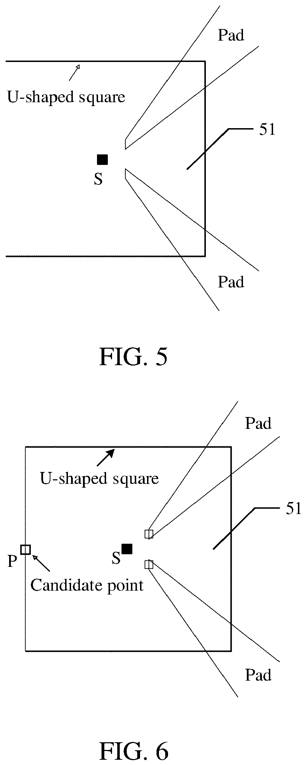

As shown in FIG. 5, by using an example in which the first site is a pad, a location region 51 corresponding to the pad is a rectangle (for example, a square). A left side of the rectangle is an opening (forming a U-shaped square), indicating that the routing orientation is on the left side of the pad. For example, the U-shaped square is centered on a reference point S (shown as the small black square in the figure) maintained at a fixed distance from a head connection of the pad. In this way, regardless of an orientation of the pad, a relative location of the U-shaped square and the pad is fixed. A side length of the U-shaped square may be adjusted as required. The U-shaped square surrounds a head of the pad, forming a square region. During automatic routing, it is specified that an automatically routed line (other than a line corresponding to the planning guidance path) on the chip layout cannot enter or pass through the region (namely, a location region corresponding to each site in the chip layout) in which the U-shaped square is located, to standardize a docking location of the line and the pad and make room for the planning guidance path.

By using a simple plane graphic (for example, a rectangle) to define the location region of the site, the location of the site on the layout can be defined very simply and intuitively, so that the location of the site on the layout can be clearly described by using some simple data (for example, coordinate and size information of the plane graphic). In addition, in addition to using the rectangle to define the location region of the site, this application is not limited to using other plane graphics, such as a circle, a rhombus, and a trapezoid, to define the location region of the site, which all fall within the protection scope of this application.

As shown in FIG. 6, before the line is about to enter the U-shaped square, to standardize an entry direction and an entry location that are of the line and connect the line with the planning guidance path, a candidate point P needs to be arranged. The candidate point P is located at a midpoint location of an opening of the U-shaped square, and the line and the planning guidance path need to be connected at the candidate point P. In other words, the candidate point P is a reference point, and the line and the planning guidance path need to be connected at this candidate point P.

In some embodiments, the planning guidance path includes n path lines, the first site includes n connection points, the n path lines are in a one-to-one correspondence with the n connection points, and n is a positive integer. For example, n may be 1, or may be 2 or a value greater than 2. A first end of an i^{th} path line in the n path lines is connected to an i^{th} connection point in the n connection points, and i is a positive integer less than or equal to n. Optionally, the n path lines are parallel to each other in a case that n is greater than 1. For example, n is equal to two, and two path lines are parallel, to implement automatic routing of a CPW in a quantum chip. The CPW is generally two parallel microwave transmission lines.

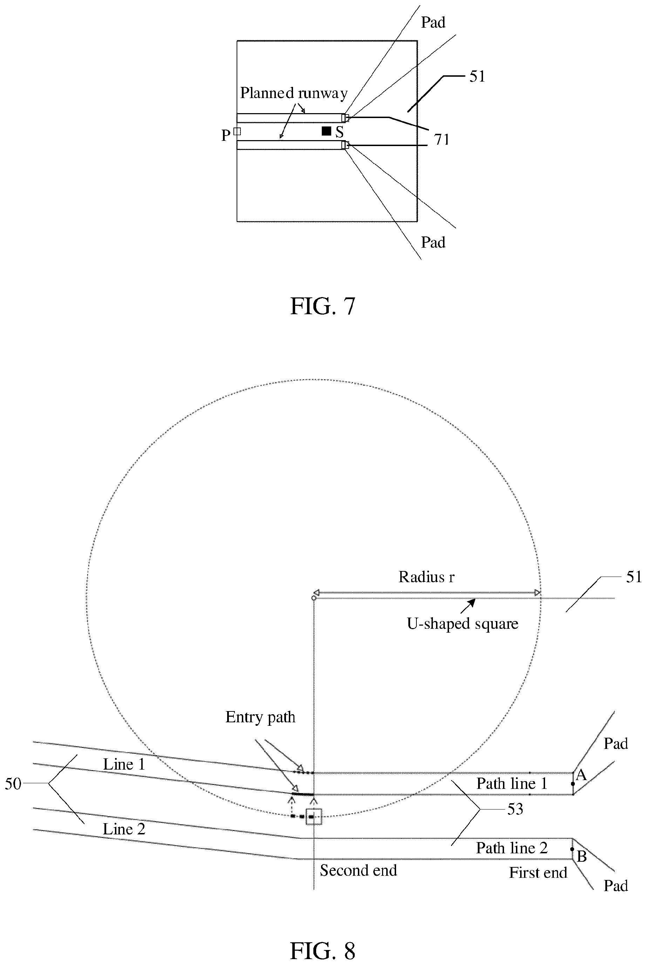

The connection point is a point that is at the site and is configured for planning routing. The n path lines are connected to the n connection points correspondingly. As shown in FIG. 7, the planning guidance path is two straight lines that are parallel to each other and have a fixed length and a fixed width. A width and spacing that are of the guidance path are consistent with a routing line, and a length depends on a size of the U-shaped square 51. The planning guidance path is within the U-shaped square 51 and is located in the middle of the U-shaped square 51. Connection points 71 are also located in the middle of the U-shaped square 51. An end (a second end) of the planning guidance path starts from the candidate point P, and an other end (a first end) is connected to the connection points 71 of the pad. Two parallel path lines are connected to the two connection points 71 of the pad respectively. Optionally, the path line is a straight line. Laying of the planning guidance path can guide the line, to be connected to the pad straightly and smoothly.

In addition, in some embodiments, if there are a plurality of connection points at the site (for example, there are two connection points on the pad), a plurality of path lines are arranged, and each path line is connected to one connection point at the site, to ensure that each connection point at the site can be accurately and smoothly connected, and because the path lines are parallel to each other, problems such as staggering and interleaving in routing do not occur, making the routing clear and reliable.

Step 420: Obtain, according to the location region and the routing orientation, a first route segment connecting a second site of the chip layout and a second end of the planning guidance path.

The second site of the chip layout may be any site different from the first site in the chip layout. Through the method provided in this embodiment, a routing line connecting the second site and the first site can be automatically arranged.

A location of the first site in the chip layout can be determined according to the location region of the first site, and an orientation from which a line is connected to the first site can be determined according to the routing orientation of the first site. After the foregoing location region and the routing orientation are determined, the first route segment connecting the second site of the chip layout and the second end of the planning guidance path may be arranged. The second end of the planning guidance path is an end other than the first end in two ends of the planning guidance path. The first end of the planning guidance path has been described above, and is an end connected to the first site.

As shown in FIG. 8, it is assumed that there is an element on the chip layout in a left part of the figure. An endpoint of the element needs to be connected to the pad through a line. When automatically arranging the line connecting the endpoint of the element and the pad, routing may be started from the endpoint of the element to the location region 51 in which a solder point is located, and the endpoint is connected to a second end (namely, a left end of a planning guidance path 53 in the figure) of the planning guidance path 53 according to a routing orientation (a left orientation of the location region 51) corresponding to the solder point, to arrange a first route segment 50. The first route segment 50 includes two parallel lines 1 and 2.

In some embodiments, routing is started from the second site to the location region, and to the second end of the planning guidance path according to the routing orientation, to obtain the first route segment in a topology routing manner.

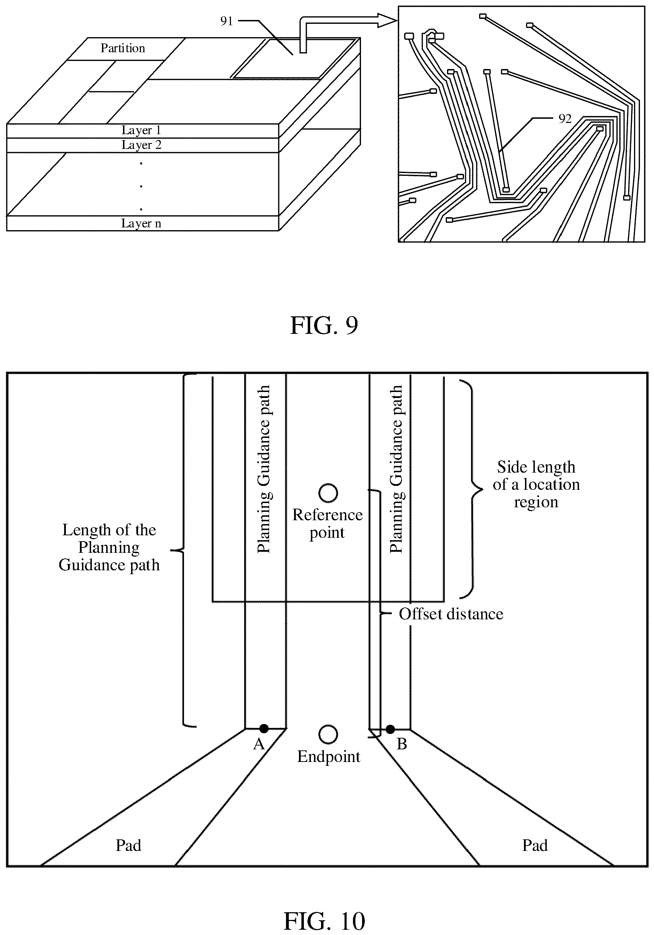

Topology routing is a technology that uses topology to perform automatic flexible routing, and is often configured for connection of lines between elements in integrated circuit and printed circuit board (PCB) design. A theory of topology is applied to cartography, transportation planning, computer science, and robotics development. Topology routing is applicable to a multilayer routing structure. An automatic routing tool designed by using a topology analysis technology may well avoid dependence on a shape and coordinates that are of an obstacle, and has more tolerance in selection of a routing path and a routing direction. A topology routing machine can arrange the routing path according to a circuit routing rule, and may also collocate with a plurality of routing algorithms to optimize the path. Compared with another routing method, topology routing is more flexible, for ease of adjusting a line width, space spacing, growth design, and the like. In addition, topology routing avoids a case of local congestion that often occurs in the another routing method. As shown in FIG. 9, the chip may include a plurality of functional layers. Each functional layer may be divided into a plurality of partitions. A topology routing result of a specified partition 91 may be shown on the right of FIG. 9. In the figure, two ends of a connection line 92 are two connection points. The connection line 92 is recorded as a line connecting the two connection points.

In this embodiment of this application, automatic routing is performed in a topology routing manner. In this way, dependence on the shape and coordinates that are of the obstacle can be well avoided, and there are more tolerance and flexibility in the selection of the routing path and the routing direction. In addition, lines passing through location regions respectively corresponding to sites on the chip layout can be automatically avoided, line intersection is avoided, and rationality and accuracy of line layout are improved.

Step 430: Obtain, based on the planning guidance path, a second route segment connecting the second end of the planning guidance path and the first site.

The first end of the planning guidance path is connected to the first site. For example, as shown in FIG. 8, a right end of the planning guidance path 53 is connected to a connection point A of the first site (the pad). Therefore, according to the planning guidance path, the second route segment connecting the second end of the planning guidance path and the first site may be arranged along the planning guidance path. As shown in FIG. 8, according to the planning guidance path 53, the second end (the left end of the planning guidance path 53) of the planning guidance path 53 is connected to the connection point A of the first site, to arrange the second route segment. The second route segment includes two parallel lines 1 and 2, which are respectively a line corresponding to a path line 1 and a line corresponding to a path line 2.

Step 440: Obtain, based on the first route segment and the second route segment, a connection route between the second site and the first site.

After the first route segment and the second route segment are arranged, the first route segment is connected to the second route segment to obtain the connection route between the second site and the first site. As shown in FIG. 8, the pad includes the upper connection point A and a lower connection point B, the line 1 is connected to the line corresponding to the path line 1, and a route connected to the upper connection point A of the pad may be arranged. The line 2 is connected to the line corresponding to the path line 2, and a route connected to the lower connection point B of the pad, namely, an entry path shown in FIG. 8, may be arranged.

The routing planning information corresponding to the chip layout may include the planning information of the at least one site in the chip layout. For each site in the chip layout, the method described in the foregoing embodiment may be used, and a connection route corresponding to the site is automatically arranged. In some embodiments, after routing on the chip layout according to the routing planning information is completed, a chip layout for chip manufacturing is generated. For example, the to-be-routed chip layout may be a layout design file. The layout design file includes information such as a shape, an area, and a location that are of each hardware unit on the chip and in the chip layout. Through the foregoing automatic routing, routing information for connecting each site may be added in the layout design file, and a layout design file with the routing information is finally generated. The layout design file with the routing information can be configured for chip manufacturing.

In some embodiments, to further improve routing quality, a portion of the first route segment connected to the second end of the planning guidance path is curved. Optionally, a length and a curvature that are of the portion may be determined by an automatic routing program, or may also be defined in the foregoing routing planning information. This is not limited in this application. For example, as shown in FIG. 8, when the line 1 is connected to a second end (a left endpoint of the planning guidance path 53) of the path line 1, a portion of the line 1 close to the path line 1 is a curve (namely, an arc) instead of a straight line, to make the connection portion smoother and more flexible. Optionally, the arc is taken from a circle whose diameter is the side length of the U-shaped square.

In the technical solutions provided in the embodiments of this application, through the routing planning information corresponding to the chip layout, the location region, the routing orientation, and the planning guidance path that are of each site included in the chip layout are defined, so that the automatic routing program can automatically arrange routes connecting each point, thereby improving routing efficiency. In addition, by defining the location region, the routing orientation, and the planning guidance path that are of the site, the automatic routing program can accurately locate the site, connect to the site from an accurate orientation when arranging a route connecting the site, and connect to the site along a path planned along the guidance path when approaching the site, which can effectively avoid a problem of an inaccurate connection location or even connection failure, improving accuracy of routing connection.

In some embodiments, the routing planning information corresponding to the foregoing chip layout is pre-designed and defined in a file. The file may be referred to as a routing planning file, and the routing planning information corresponding to the chip layout is stored in the routing planning file.

The routing planning information corresponding to the chip layout includes planning information of each site in the chip layout. By using the first site as an example, the planning information of the first site includes:
(1) coordinate information of an endpoint corresponding to the first site;
(2) an offset distance between the endpoint corresponding to the first site and the reference point corresponding to the first site;
(3) size information of the location region of the first site; and
(4) orientation indication information of the routing orientation of the first site.

The endpoint corresponding to the first site may be a connection point of the first site, or may be a point determined according to a connection point of the first site, and is configured for indicating a location of the first site or a location of the connection point of the first site.

The reference point corresponding to the first site is a point for determining the location region of the first site. Coordinate information of the reference point corresponding to the first site may be determined according to the coordinate information of the endpoint corresponding to the first site, and the offset distance between the endpoint corresponding to the first site and the reference point corresponding to the first site. Optionally, the reference point corresponding to the first site may be a center point of the location region of the first site.

The size information of the location region of the first site is configured for defining a size of the location region of the first site. For example, when the location region of the first site is a rectangle, the size information of the location region may include a side length of the rectangle.

The orientation indication information of the routing orientation of the first site is configured for defining the routing orientation of the first site. For example, when the routing orientation includes two orientations: above and below, the orientation indication information may be represented by using two different values: 0 and 1, or -1 and 1, where one value indicates above, and the other value indicates below. For another example, when the routing orientation includes four orientations: above, below, left, and right, the orientation indication information may be represented by using four different values.

The automatic routing program may determine the location region, the routing orientation, and the planning guidance path that are of the first site according to the planning information of the first site. Optionally, the coordinate information of the reference point corresponding to the first site is determined according to the coordinate information of the endpoint corresponding to the first site and the offset distance, and the location region is determined according to the coordinate information of the reference point corresponding to the first site and the size information of the location region; the routing orientation of the first site is determined according to the orientation indication information of the routing orientation of the first site; and the planning guidance path of the first site is determined according to the size information of the location region of the first site and the offset distance.

For example, as shown in FIG. 10, an example in which the first site is a pad is used. The pad includes two connection points: a left connection point A and a right connection point B respectively. Planning information of the pad may include: coordinate information of an endpoint, for example, coordinates coord=(x, y) in a two-dimensional rectangular coordinate system corresponding to a plane on which the chip layout is located, where x represents an abscissa of the endpoint, and y represents an ordinate of the endpoint; an offset distance between the endpoint and the reference point, recorded as offset; the size information of the location region (the U-shaped square), for example, the side length of the U-shaped square, recorded as neighborhood; and the orientation indication information of the routing orientation, for example, 1 representing that the opening of the U-shaped square faces upward, and the route is accessed from the above of the U-shaped square. Optionally, a length L of the planning guidance path = offset + neighborhood/2. Optionally, in FIG. 10, only that offset is greater than neighborhood/2 is used as an example. In this case, the endpoint is located outside the U-shaped square. In some other embodiments, offset may also be less than or equal to neighborhood/2. In this case, the endpoint is located inside the U-shaped square or on a side of the U-shaped square.

For example, the foregoing routing planning file may be a proto file. In the proto file, two ends of each route are defined as terminal (endpoint) types, and each terminal corresponds to an "airport". A terminal has corresponding parameters such as coord, offset, and neighborhood. Coord and offset determine a location of the "airport", and neighborhood determines a size of the "airport".

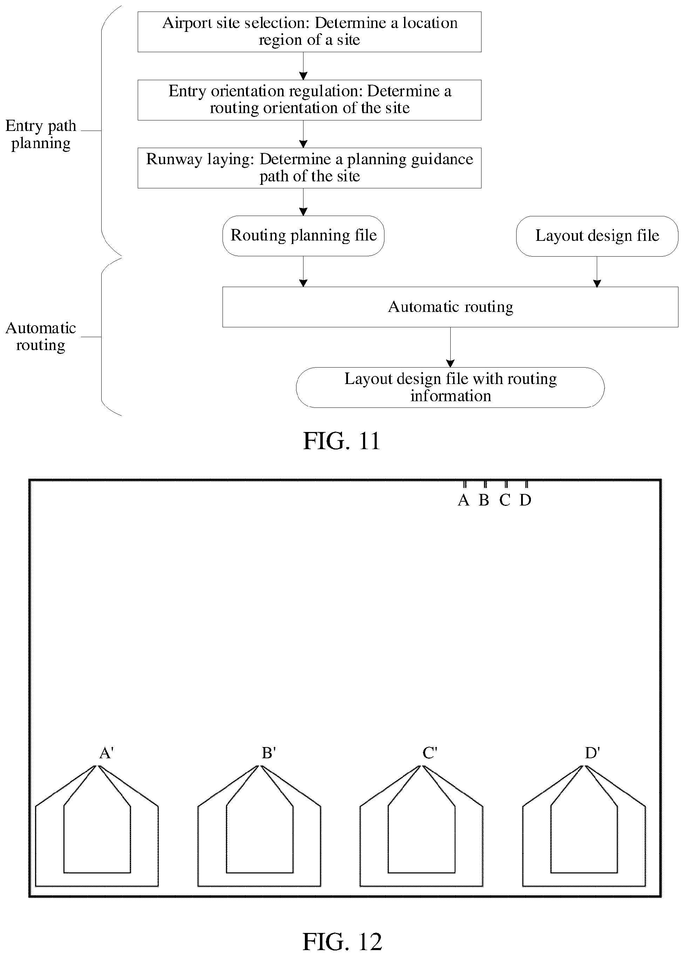

As shown in FIG. 11, according to the method described above, a technician pre-designs the routing planning information corresponding to the chip layout according to the layout design file of the chip layout, and generates a routing planning file. Entry path planning of the site in the chip layout includes: airport site selection (determining the location region of the site), an entry orientation regulation (determining the routing orientation of the site), and guidance path laying (determining the planning guidance path of the site). Through the foregoing steps, the planning information of each site may be determined and stored in the routing planning file. Afterwards, through the automatic routing program, according to the layout design file of the chip layout and the routing planning file, automatic routing is performed by using the method described in the embodiments above, and the layout design file with the routing information is finally generated.

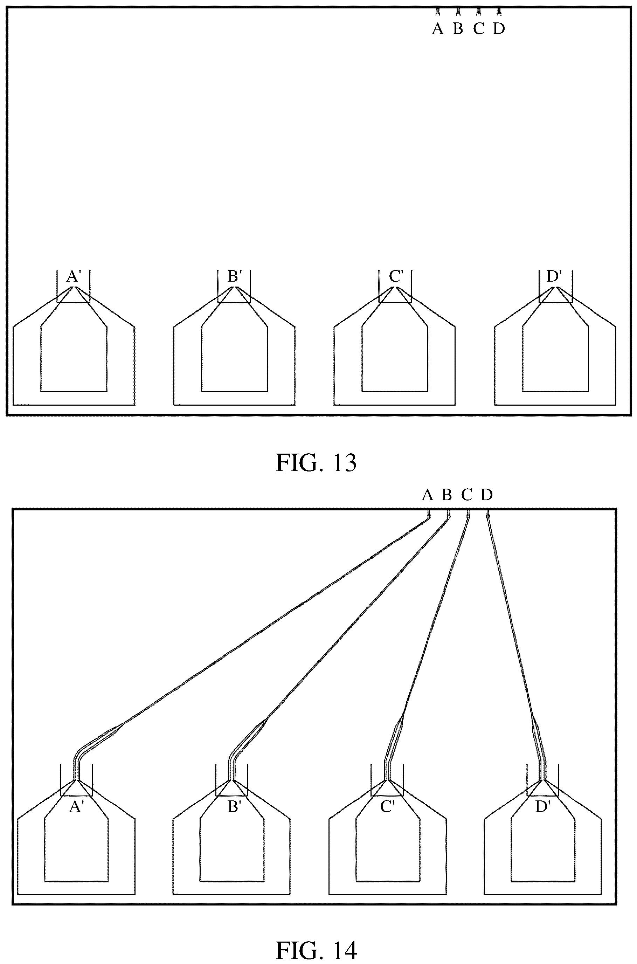

The following describes a working principle of the automatic routing method provided in this application through examples shown in FIG. 12 to FIG. 14. As shown in FIG. 12, routing connection needs to be performed between four sites A, B, C, and D and corresponding four sites A', B', C', and D'. First, according to a setting in the routing planning file, a docking algorithm determines the location region of the site and simultaneously specify the routing orientation of the site. As shown in FIG. 13, the location region and the routing orientation that are of the site may be seen. The orientation ensures direction correctness of routing at the connection point. A routing result in FIG. 14 shows correctness of the docking algorithm. It may be seen from FIG. 14 that, the location region arranged by the docking algorithm limits an entry direction of a route around the location region, to ensure the correctness of the routing.

It may be seen that, without the docking algorithm, as shown in FIG. 1, a pin cannot be effectively connected to the pad correctly. However, after using the docking technology, as shown in FIG. 14, accurate automatic connection between the pin and the pad is successfully implemented.

The docking technology provided in this application can be well used in the superconducting quantum chip layout to accurately connect the pin to the complex polygonal pad with different orientations around the layout during automatic routing. A docking process is convenient and efficient, and does not affect or interfere with a surrounding route. The solution is more tolerance in the selection and direction of the routing path, and may be expanded to a larger-scale and more complex architecture, and even quantum chip design for a platform other than superconducting.

The following is an apparatus embodiment of this application, which can be used to perform the method embodiments of this application. For details not disclosed in the apparatus embodiment of this application, reference may be made to the method embodiments of this application.

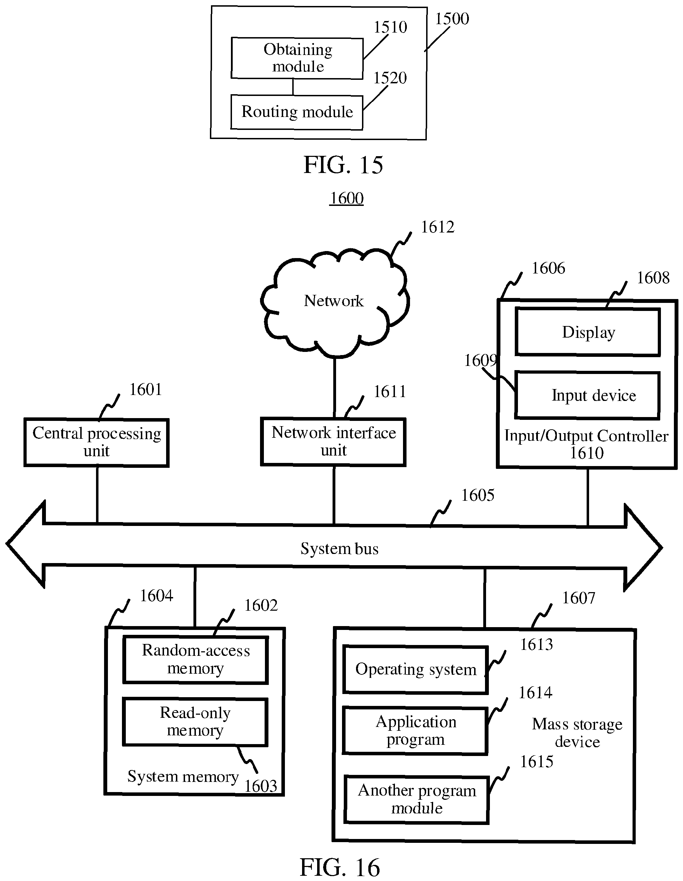

FIG. 15 is a block diagram of a routing apparatus for a chip layout according to an embodiment of this application. The apparatus has a function of implementing the routing method example of the foregoing chip layout, and the function may be implemented by hardware or by hardware executing corresponding software. The apparatus 1500 may be the computer device described above, or may be disposed in the computer device. The apparatus 1500 may include: an obtaining module 1510 and a routing module 1520.

The obtaining module 1510 is configured to obtain a to-be-routed chip layout and routing planning information corresponding to the chip layout, the routing planning information including planning information of a first site in the chip layout, the planning information defining a location region, a routing orientation, and a planning guidance path that are of the first site, and a first end of the planning guidance path being connected to the first site;

The routing module 1520 is configured to obtain, according to the routing orientation, a first route segment connecting a second site of the chip layout and a second end of the planning guidance path; obtain, based on the planning guidance path, a second route segment connecting the second end of the planning guidance path and the first site; and obtain, based on the first route segment and the second route segment, a connection route between the second site and the first site.

In some embodiments, the routing module 1520 is configured to start routing from the second site to the location region, and to the second end of the planning guidance path according to the routing orientation, to obtain the first route segment in a topology routing manner.

In some embodiments, the location region is defined by using a plane graphic surrounding a reference point corresponding to the first site, and the routing orientation is defined on an edge of the plane graphic.

In some embodiments, the plane graphic is a rectangle, and the routing orientation is defined on an edge of the rectangle.

In some embodiments, the planning guidance path includes n path lines, the first site includes n connection points, the n path lines are in a one-to-one correspondence with the n connection points, and n is a positive integer; and a first end of an i^{th} path line in the n path lines is connected to an i^{th} connection point in the n connection points, and i is a positive integer less than or equal to n.

In some embodiments, the n path lines are parallel to each other in a case that n is greater than 1.

In some embodiments, a portion of the first route segment connected to the second end of the planning guidance path is curved.

In some embodiments, the planning information includes:
coordinate information of an endpoint corresponding to the first site;
an offset distance between the endpoint corresponding to the first site and the reference point corresponding to the first site;
size information of the location region; and
orientation indication information of the routing orientation.

In some embodiments, the apparatus 1500 further includes a determination module (not shown in FIG. 15) configured to determine coordinate information of the reference point corresponding to the first site by using the coordinate information of the endpoint corresponding to the first site and the offset distance, and determine the location region by using the coordinate information of the reference point corresponding to the first site and the size information of the location region; determine the routing orientation according to the orientation indication information of the routing orientation; and determine the planning guidance path by using the size information of the location region and the offset distance.

In some embodiments, the first site is a pad.

In some embodiments, the pad is of a concave polygonal shape, and the pad includes at least one connection point.

In some embodiments, the apparatus 1500 further includes a generation module (not shown in FIG. 15) configured to generate, after routing on the chip layout according to the routing planning information is completed, a chip layout for chip manufacturing.

In some embodiments, the chip layout is a chip layout of a quantum chip.

In the embodiments of this application, through the routing planning information corresponding to the chip layout, the location region, the routing orientation, and the planning guidance path that are of each site included in the chip layout are defined, so that an automatic routing program can automatically arrange routes connecting each point, thereby improving routing efficiency. In addition, by defining the location region, the routing orientation, and the planning guidance path that are of the site, the automatic routing program can accurately locate the site, connect to the site from an accurate orientation when arranging a route connecting the site, and connect to the site along a path planned along the guidance path when approaching the site, which can effectively avoid a problem of an inaccurate connection location or even connection failure, improving routing accuracy.

When the apparatus provided in the foregoing embodiments implements functions of the apparatus, the division of the foregoing functional modules is merely an example for description. In the practical application, the functions may be assigned to and completed by different functional modules according to the requirements, that is, the internal structure of the device is divided into different functional modules, to implement all or some of the functions described above. In addition, the apparatus and method embodiments provided in the foregoing embodiments belong to the same conception. For the specific implementation process, reference may be made to the method embodiments, and details are not described herein again.

FIG. 16 is a structural block diagram of a computer device according to an embodiment of this application. The computer device is configured to implement the routing method for the chip layout provided in the foregoing embodiments. Specifically,
the computer device 1600 includes a central processing unit (CPU) 1601, a system memory 1604 including a random access memory (RAM) 1602 and a read-only memory (ROM) 1603, and a system bus 1605 connecting the system memory 1604 and the central processing unit 1601. The computer device 1600 further includes a basic input/output system (I/O) system 1606 assisting in transmitting information between devices in a computer, and a mass storage device 1607 configured to store an operating system 1613, an application program 1614, and another application module 1615.

The basic input/output system 1606 includes a display 1608 configured to display information and an input device 1609 such as a mouse and a keyboard for a user to input information. The display 1608 and the input device 1609 are both connected to the central processing unit 1601 through an input/output controller 1610 connected to the system bus 1605. The basic input/output system 1606 may further include the input/output controller 1610 for receiving and processing input from a plurality of other devices such as a keyboard, a mouse, an electronic stylus, or the like. Similarly, the input/output controller 1610 further provides output to a display screen, a printer, or other types of output devices.

The mass storage device 1607 is connected to the central processing unit 1601 through a mass storage controller (not shown) connected to the system bus 1605. The mass storage device 1607 and an associated computer-readable medium provide non-volatile storage for the computer device 1600. That is, the mass storage device 1607 may include a computer-readable medium (not shown) such as a hard disk or a compact disc ROM (CD-ROM) drive.

In general, the computer-readable medium may include a computer storage medium and a communication medium. The computer storage medium includes volatile and non-volatile, removable and non-removable media that are configured to store information such as computer-readable instructions, data structures, program modules, or other data and that are implemented by using any method or technology. The computer storage medium includes a RAM, a ROM, an erasable programmable read only memory (EPROM), an electrically erasable programmable read only memory (EEPROM), a flash memory or another solid-state memory, a CD-ROM, a digital video disc (DVD) or another optical memory, a tape cartridge, a magnetic cassette, a magnetic disk memory, or another magnetic storage device. Certainly, those skilled in the art may learn that the computer storage medium is not limited to the above. The foregoing system memory 1604 and mass storage device 1607 may be collectively referred to as a memory.

According to the embodiments of this application, the computer device 1600 may further be connected, through a network such as the Internet, to a remote computer on the network. That is, the computer device 1600 may be connected to a network 1612 by using a network interface unit 1611 connected to the system bus 1605, or may be connected to another type of network or a remote computer system (not shown) by using a network interface unit 1611.

In an example embodiment of this application, a computer-readable storage medium is further provided. The computer-readable storage medium stores a computer program. The computer program, when executed by a processor, implements the routing method for the foregoing chip layout.

Optionally, the computer-readable storage medium may include: a read-only memory (ROM), a random-access memory (RAM), a solid state drive (SSD), an optical disc, or the like. The RAM may include a resistance random access memory (ReRAM) and a dynamic random access memory (DRAM).

In an example embodiment of this application, a computer program product is provided. The computer program product includes a computer program, and the computer program is stored in a computer-readable storage medium. A processor of a computer device reads the computer program from the computer-readable storage medium, and executes the computer program, to cause the computer device to perform the foregoing routing method for the chip layout.

In an example embodiment of this application, a chip layout is further provided, the chip layout being obtained by using the foregoing routing method for the chip layout.

It is to be understood that "plurality of" mentioned in this specification means two or more. And/or describes an association relationship for describing associated objects and represents that three relationships may exist. For example, A and/or B may represent the following three cases: Only A exists, both A and B exist, and only B exists. The character "/" generally indicates an "or" relationship between the associated objects.

The foregoing descriptions are merely exemplary embodiments of this application, but are not intended to limit this application.

## Claims

1. A routing method for a chip layout, executable by a computer device and comprising:
obtaining a to-be-routed chip layout and routing planning information corresponding to the chip layout, the routing planning information comprising planning information of a first site in the chip layout, the planning information defining a location region, a routing orientation, and a planning guidance path that are of the first site, and a first end of the planning guidance path being connected to the first site;
obtaining, according to the routing orientation, a first route segment connecting a second site of the chip layout and a second end of the planning guidance path;
obtaining, based on the planning guidance path, a second route segment connecting the second end of the planning guidance path and the first site; and
obtaining, based on the first route segment and the second route segment, a connection route between the second site and the first site.

2. The method according to claim 1, wherein the obtaining, according to the location region and the routing orientation, a first route segment connecting a second site of the chip layout and a second end of the planning guidance path comprises:
starting routing from the second site to the location region, and to the second end of the planning guidance path in the routing orientation, to obtain the first route segment in a topology routing manner.

3. The method according to claim 1 or 2, wherein the location region is defined by using a plane graphic surrounding a reference point corresponding to the first site, and the routing orientation is defined on an edge of the plane graphic.

4. The method according to claim 3, wherein the plane graphic is a rectangle, and the routing orientation is defined on an edge of the rectangle.

5. The method according to any one of claims 1 to 4, wherein the planning guidance path comprises n path lines, the first site comprises n connection points, the n path lines are in a one-to-one correspondence with the n connection points, and n is a positive integer; and
a first end of an i^{th} path line in the n path lines is connected to an i^{th} connection point in the n connection points, and i is a positive integer less than or equal to n.

6. The method according to claim 5, wherein the n path lines are parallel to each other in a case that n is greater than 1.

7. The method according to any one of claims 1 to 6, wherein a portion of the first route segment connected to the second end of the planning guidance path is curved.

8. The method according to any one of claims 1 to 7, wherein the planning information of the first site comprises:
coordinate information of an endpoint corresponding to the first site;
an offset distance between the endpoint corresponding to the first site and the reference point corresponding to the first site;
size information of the location region; and
orientation indication information of the routing orientation.

9. The method according to claim 8, further comprising:
determining coordinate information of the reference point corresponding to the first site by using the coordinate information of the endpoint corresponding to the first site and the offset distance, and determining the location region by using the coordinate information of the reference point corresponding to the first site and the size information of the location region;
determining the routing orientation according to the orientation indication information of the routing orientation; and
determining the planning guidance path by using the size information of the location region and the offset distance.

10. The method according to any one of claims 1 to 9, wherein the first site is a pad,

11. The method according to claim 10, wherein the pad is of a concave polygonal shape, and the pad comprises at least one connection point.

12. The method according to any one of claims 1 to 11, wherein after the obtaining, based on the first route segment and the second route segment, a connection route between the second site and the first site, the method further comprises:
generating, after routing on the chip layout according to the routing planning information is completed, a chip layout for chip manufacturing.

13. The method according to any one of claims 1 to 12, wherein the chip layout is a chip layout of a quantum chip.

14. A routing apparatus for a chip layout, the apparatus comprising:
an obtaining module, configured to obtain a to-be-routed chip layout and routing planning information corresponding to the chip layout, the routing planning information comprising planning information of a first site in the chip layout, the planning information defining a location region, a routing orientation, and a planning guidance path that are of the first site, and a first end of the planning guidance path being connected to the first site;
a routing module, configured to obtain, according to the routing orientation, a first route segment connecting a second site of the chip layout and a second end of the planning guidance path; obtain, based on the planning guidance path, a second route segment connecting the second end of the planning guidance path and the first site; and obtain, based on the first route segment and the second route segment, a connection route between the second site and the first site.

15. A computer device, comprising a processor and a memory, the memory storing a computer program, the processor being configured to execute the computer program to implement the method according to any one of claims 1 to 13.

16. A computer-readable storage medium, storing a computer program, the computer program being loaded and executed by a processor to implement the method according to any one of claims 1 to 13.

17. A computer program product, comprising a computer program, the computer program being loaded and executed by a processor to implement the method according to any one of claims 1 to 13.

18. A chip layout, obtained by using the method according to any of claims 1 to 13.
